# EUROPÄISCHE PATENTANMELDUNG

(11) **EP 1 536 531 A1**
(43) Veröffentlichungstag der Anmeldung: **01.06.2005**
(21) Anmeldenummer: 04027605.7
(22) Anmeldetag: 20.11.2004
(51) Int. Cl.: H01S 5/34, H01S 5/343

(54) **Quantenkaskadenlaser**

(30) Priorität: 29.11.2003 DE 10355949
(71) Anmelder: Forschungszentrum Rossendorf e.V., 01328 Dresden (DE)
(72) Erfinder: Dekorsy, Thomas, Dr., 01454 Grosserkmannsdorf (DE); Helm, Manfred, Prof. Dr., 01309 Dresden (DE); Georgiev, Nikolai, Dr., Sofia 1000 (BG); Künzel, Harald, Dr., 10587 Berlin (DE)

(57) **Zusammenfassung**

Der Erfindung liegt die Aufgabe zugrunde, einen Quantenkaskadenlaser mit einer Emissionswellenlänge unterhalb von 3,4 µm und oberhalb von 1,5 µm zu realisieren. Dabei soll die technische Lösung nicht den Nachteil eingebauter piezoelektrischer Felder aufweisen und das Materialsystem soll gitterangepasst auf gängige Halbleitersubstrate bei einer verbesserten Prozessierbarkeit aufwachsbar sein.

Die Erfindung beinhaltet, dass die Halbleiter-Vielschichtstruktur aus InGaAs als Material der Topfschicht und AlAsSb als Material der Barrierenschicht besteht. Vorteilhaft ist es, wenn die Dicke mindestens einer Topfschicht im optisch aktiven Bereich zwischen 1 und 4 nm beträgt.

## Beschreibung

Die Erfindung betrifft Quantenkaskadenlaser nach dem Oberbegriff des Anspruchs 1.

Quantenkaskadenlaser sind unipolare optoelektronische Halbleiterbauelemente, die Laserlicht mit Wellenlängen im mittleren bis fernen infraroten Spektralbereich, d.h. von 3,4 µm bis 110 µm emittieren. Für Wellenlängen größer als 4 µm stellen diese Laser im Vergleich zu anderen Lasern, insbesondere bipolaren Interbandlaser, die derzeit technisch am weitesten fortgeschrittenen Quellen für Laserstrahlung dar.

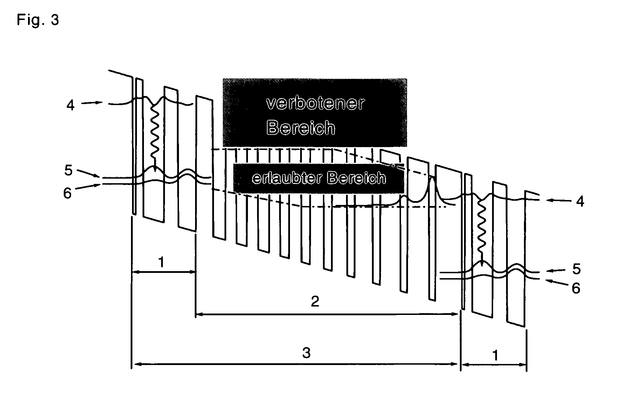

Quantenkaskadenlaser wurden erstmals 1994 berichtet und wurden seitdem konsequent weiterentwickelt mit den Zielen der Steigerung des Wirkungsgrades, der Erhöhung der Betriebstemperatur, der Erweiterung des Wellenlängenbereiches, und der Erzielung von Dauerstrichbetrieb. Eine Übersicht über diese Entwicklung gibt der Artikel von J. Faist et al., "Quantum Cascade Lasers", Kap. 1, S. 1 - 83, Semiconductors and Semimetals, Vol. 66.
In der Patentliteratur sind verschiedene Ausführungen von Quantenkaskadenlasern insbesondere in den Patenten US 54 57 709, US 55 09 024, US 55 09 025, US 57 45 516, US 57 99 026, US 59 36 989 dargelegt.
Der Leitungsbandverlauf eines Quantenkaskadenlasers dem Stand der Technik entsprechend ist in Fig. 3 dargestellt. Die dargestellte Vielfachstruktur wird mehrfach wiederholt, was zu der Kaskadierung der Lichtemission in dieser Struktur führt. Quantenkaskadenlaser setzten sich aus einer Vielfachstruktur 3 von Halbleiterschichten zusammen, die ihrerseits in einen optisch aktiven Bereich 1 und in einen Übergangsbereich 2 unterteilt werden. Die Vielfachstruktur besteht aus der alternierenden Abfolge von mindestens zwei verschiedene Halbleitern unterschiedlicher Bandlückenenergie. Elektronischer Transport durch die Vielfachstruktur wird durch das Anlegen eines elektrischen Feldes erzielt, das zur Verkippung der Bandstruktur gegenüber dem feldfreien Fall führt. Dies resultiert in dem verkippten, stufenartigen Potentialverlauf, wie in Fig. 3 dargestellt. Der Halbleiter mit der geringeren Bandlückenenergie bildet das Topfmaterial und der mit der größeren Bandlücke das Barrierenmaterial. Der energetische Unterschied der Leitungsbandkante des Topfmaterials und der Leitungsbandkante des Barrierenmaterials wird Leitungsbanddiskontinuität genannt. Liegt die Schichtdicke des Topfmaterials unterhalb der de-Broglie-Wellenlänge der Elektronen, so tritt eine Quantisierung der elektronischen Energieniveaus ein. Der Abstand dieser Energieniveaus erhöht sich mit Abnahme der Schichtdicke des Topfes, mit der Zunahme der Leitungsbanddiskontinuität und mit Zunahme der Schichtdicke der den Topf umgebenden Barrieren. Zusätzlich kann die Lage der Energieniveaus durch Gitterverspannungen modifiziert werden. Diese tritt auf, wenn die aufeinanderfolgenden Halbleiterschichten nicht die gleiche Gitterkonstante besitzen.
Die in Fig. 3 dargestellten Energieniveaus werden durch eine kombinierte Lösung der Schrödinger-Gleichung und der Poisson-Gleichung berechnet.
Im optisch aktiven Bereich erzeugt ein Elektron durch den Übergang zwischen dem oberen Energieniveau **4** in das untere Energieniveau **5** ein Photon, das im Laserbetrieb zur Verstärkung durch stimulierte Emission beiträgt. Anschließend relaxiert das Elektron in sehr kurzer Zeit in das Energieniveau **6** und bewegt sich durch den Übergangsbereich **2**. Dieser ist in bekannter Weise dotiert, um die Dichte der Elektronen zu erhöhen. Der Übergangsbereich ist in der Art und Weise ausgebildet, dass Elektronen im oberen Niveau des optisch aktiven Bereichs nicht ohne Energieabgabe durch Photonenemission direkt in den Übergangsbereich gelangen können. Zu diesem Zweck wird der Übergangsbereich so ausgeführt, dass für Elektronen mit höherer Energie keine quantenmechanisch erlaubten Zustände existieren. Elektronen gelangen aus dem optisch aktiven Bereich über das unterste Energieniveau **6** durch quantenmechanisch erlaubte Energieniveaus im Übergangsbereich in das oberste Energieniveau des benachbarten optisch aktiven Bereichs. Gegenwärtig werden Quantenkaskadenlaser hauptsächlich in folgenden Halbleitersystemen realisiert, die sich gitterangepasst, d.h. ohne Gitterverspannung, auf einem binären Substrat (GaAs, InP, InAs, GaSb) aufwachsen lassen: Topfmaterial GalnAs, Barrierenmaterial AllnAs auf InP Substrat; Topfmaterial GaAs, Barrierenmaterial GaAlAs auf GaAs Substrat. Abweichungen von der gitterangepassten Komposition führen zu Verspannungen. Die gesamte Vielschichtstruktur des Quantenkaskadenlasers kann jedoch bei Abweichung von der gitterangepassten Komposition der Einzelschichten, d.h. verspannt, aufgewachsen werden, so dass sich die Verspannungen in den einzelnen Schichten kompensieren. Diesen Fall nennt man spannungskompensiertes Wachstum.
Die Grenze für die kürzeste erreichbare Wellenlänge eines Quantenkaskadenlasers wird durch die erzielbare Energieaufspaltung des unteren Energieniveaus 5 und des oberen Energieniveaus **4** in der aktiven optischen Schicht erzielt. Diese Energieaufspaltung wird von der Materialseite durch die zur Verfügung stehenden Leitungsbanddiskontinuität begrenzt. Die bisher erzielten kürzesten Wellenlängen von Quantenkaskadenlasern sind für alle realisierten Materialsysteme in folgender Tabelle zusammengefasst:

| Nr. | Topfmaterial | Barrieren-material | Leitungsband-diskontinuität | Substrat-material, Wachstumsmodus | kürzeste erzielte Wellenlänge | Referenz |
|---|---|---|---|---|---|---|
| 1 | In_{0.53}Ga_{0.47}As | In_{0.52}Al_{0.48}As | 0,52 eV | InP, gitterangepasst | 4,2 µm | J.Faist et al., Science, Vol. 264, p. 553 (1994) |
| 2 | In_{0.7}Ga_{0.3}As | In_{0.4}Al_{0.6}As | 0,74 eV | InP, spannungs kompensiert | 3,4 µm | J.Faist et al., Appl. Phys. Lett. Vol. 72, p. 680, 1998. |
| 3 | In_{0.62}Ga_{0.38}As | In_{0.4}Al_{0.6}As | 0,725 eV | InP, spannungs kompensiert | 4,6 µm | R. Köhler et al., Appl. Phys. Lett. Vol. 76, p. 1092, 2000. |
| 4 | GaAs | Al_{0.33}Ga_{0.67}As | 0,295 eV | GaAs, gitterangepasst angepasst | 9,4 µm | C.Sirtori et al., Appl.Phys .Lett. Vol.73, p. 3486, 1998. |
| 5 | GaAs | Al_{0.45}Ga_{0.55}As | 0,39 eV | GaAs, gitterangepasst | 9,0 µm | H. Page et al., Appl. Phys. Lett. Vol. 78, p. 3529, 2001. |
| 6 | GaAs | AlAs | 1,0 eV | GaAs, gitterangepasst | 7,2 µm | L.R. Wilson et al., Appl. Phys. Lett. Vol 81, p-1378, 2002. |
| 7 | InAs/GaAs | AlAs | 1,0 eV | GaAs, gitterangepasst | 8,5 µm | D. A. Carder et al., Appl. Phys. Lett. Vol. 82, p. 3409, 2003. |
| 8 | InAs/GaAs | Al_{0.33}Ga_{0.67}As | 0,295 eV | GaAs, gitterangepasst | 7,4 µm | L.R. Wilson et al., Appl. Phys. Lett. Vol. 78, p. 413, 2001. |
| 9 | InAs | AlSb | 2,1 eV | InAs, gitterangepasst | 10 µm | K. Ohtani et al., Appl. Phys. Lett.. Vol. 82, p. 1003, 2003. |
| 10 | InAs | AlSb | 2,1 eV | GaSb, gitterangepasst | 6,7 µm | R. Teissier, Electr. Lett. Vol. 39, p. 1252, 2003. |
| 11* | InAs | AlSb | 2,1 eV | InAs, gitterangepasst | 4,6 µm | K. Ohtani und H. Ohno, Electr. Lett. Vol. 35, p. 935, 1999. |
| 12* | InAs | AlSb | 2,1 eV | GaSb, gitterangepasst | 3,7 µm | C. Becker et al. Appl. Phys. Lett. Vol. 78, p. 1029, 2001. |

Zu Nr. 11* und Nr. 12* ist zu bemerken, dass bisher keine Laser realisiert wurden, sondern nur die Vorstufe zur Lasertätigkeit, d.h. spontane Emission bzw. Elektrolumineszenz, beobachtet werden konnte.
Aus dieser Aufstellung wird klar, dass die minimal erzielbare Wellenlänge wesentlich kleiner als die entsprechende Leitungsbanddiskontinuität einer gegebenen Materialkombination ist. Bildet man das Verhältnis der Energie der emittierten Photonen zur Leitungsbanddiskontinuität, so erhält man einen Wert von kleiner 0,5, d.h. die kürzeste erreichbare Wellenlänge entspricht maximal 50% der verfügbaren Leitungsbanddiskontinuität für ein gegebenes Materialsystem.

Die US-Anmeldung 20020096675 betrifft Quantenkaskadenlaser mit Wellenlängen kürzer als 1,7 µm, die auf der Materialbasis von GaN und AlGaN Vielfachschichten realisiert werden. Dieses Materialsystem besitzt den Nachteil hoher eingebauter piezoelektrischer Felder und einer schweren Prozessierbarkeit. Zudem gibt es keine gängigen Halbleitersubstrate, auf die dieses Materialsystem gitterangepasst aufgewachsen werden kann.

Der vorliegenden Erfindung liegt die Aufgabe zugrunde, einen Quantenkaskadenlaser mit einer Emissionswellenlänge unterhalb von 3,4 µm und oberhalb von 1,5 µm zu realisieren. Dabei soll die technische Lösung nicht den Nachteil eingebauter piezoelektrischer Felder aufweisen und das Materialsystem soll gitterangepasst auf gängige Halbleitersubstrate bei einer verbesserten Prozessierbarkeit aufwachsbar sein.

Die Aufgabe wird erfindungsgemäß durch einen Quantenkaskadenlaser mit den Merkmalen des Anspruchs 1 gelöst. Den Erfindungsanspruch vorteilhaft weiterbildende Merkmale sind Gegenstand der Unteransprüche sowie der Beschreibung unter Bezugnahme auf die Ausführungsbeispiele mit den dazugehörigen Figuren zu entnehmen.

Die Erfindung eines kurzwelligen Quantenkaskadenlasers gemäß Anspruch 1 stellt die erste technische Realisierung eines Quantenkaskadenlasers mit Wellenlängen kleiner als 3,4 µm dar. Der damit erschlossene Wellenlängenbereich ist für eine Vielzahl von Anwendungen insbesondere in der Telekommunikation von technischem Interesse.

Die Erfindung wird nachfolgend unter Bezugnahme auf die Figuren der Zeichnungen an zwei Ausführungsbeispielen näher erläutert. In der zugehörigen Zeichnung zeigen:
Fig. 1 die schematische Darstellung des Leitungsbandverlaufs einer ersten Ausführungsform eines erfindungsgemäß ausgebildeten Quantenkaskadenlasers,
Fig. 2 die schematische Darstellung des Leitungsbandverlaufs einer zweiten Ausführungsform eines erfindungsgemäß ausgebildeten Quantenkaskadenlasers und
Fig. 3 die schematische Darstellung des Leitungsbandverlaufs eines Quantenkaskadenlasers als Ausführungsform gemäß des Standes der Technik.

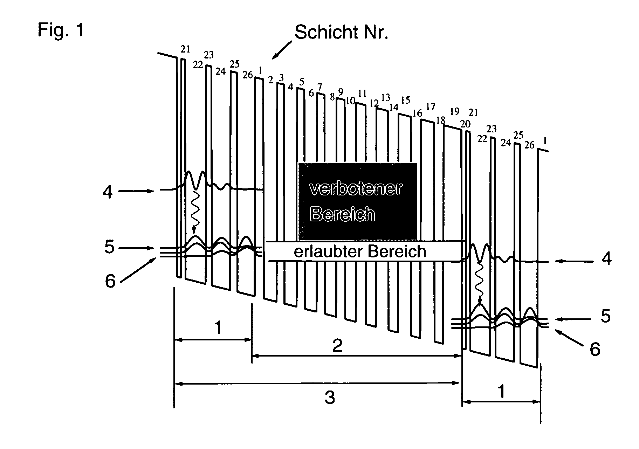

In Fig. 1 ist die schematische Darstellung des Leitungsbandverlaufs einer ersten Ausführungsform eines erfindungsgemäß ausgebildeten Quantenkaskadenlasers dargestellt. Dargestellt ist eine Periode der Vielfachschichtstruktur des Quantenkaskadenlasers. Zur Funktion der einzelnen Bereich sei auf die Beschreibung des Standes der Technik in Fig. 3 verwiesen. Das Topfmaterial ist InGaAs und das Barrierenmaterial ist AlAsSb. Die Komposition ist so gewählt, das sie gitterangepasst auf InP Substraten aufwächst. Die Valenzbanddiskontinuität zwischen Töpfen und Barrieren dieser Komposition beträgt etwa 1,6 eV. Die Übergangswellenlänge zwischen dem oberen Niveau **4** und dem unteren Niveau **5** der aktiven Schicht beträgt 3,0 µm. Die genau Schichtfolge der Struktur ist in folgender Tabelle gegeben. Die unterstrichenen Werte geben einen möglichen Bereich an, der n-Typ dotiert ist mit Volumenkonzentrationen größer 10¹⁷ cm⁻³. Die Dotierung kann sich entweder auf die Töpfe, auf die Barrieren, oder auf die Töpfe und Barrieren im Übergangsbereich erstrecken.

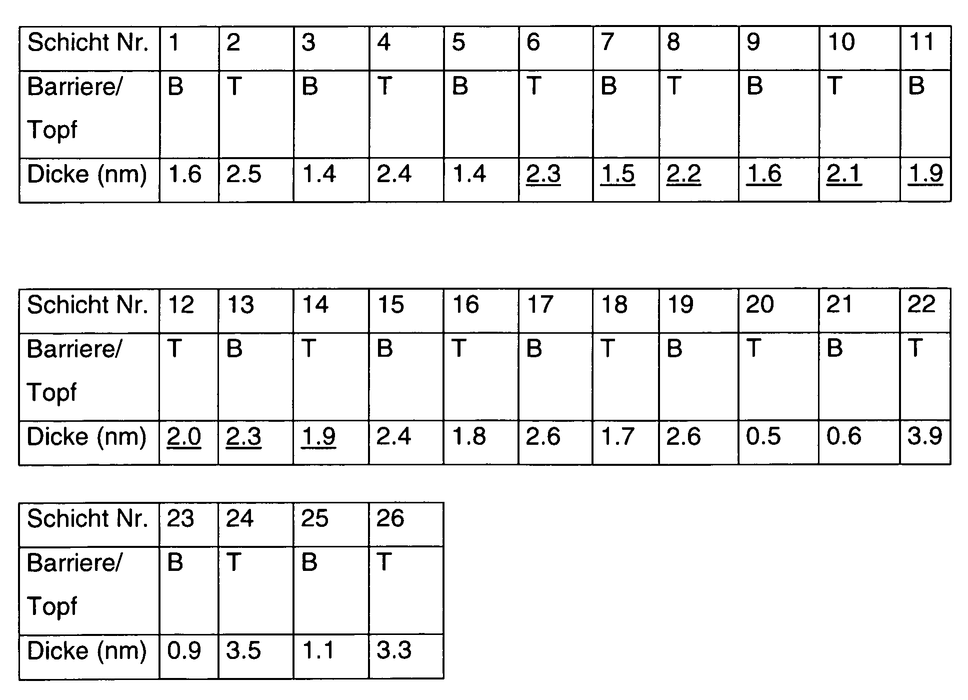

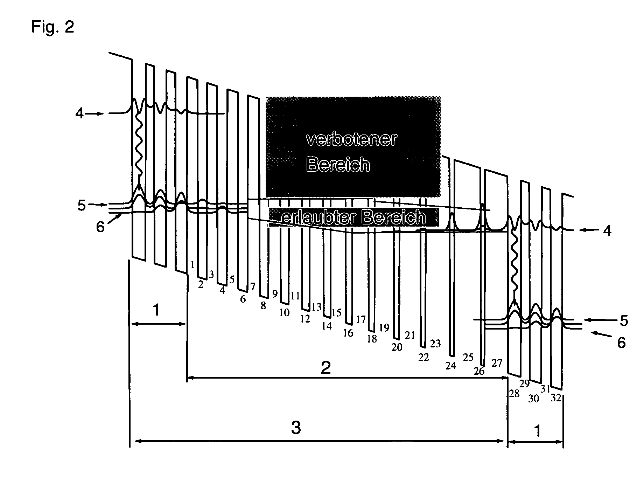

Zu Fig. 2 (Schematische Darstellung des Leitungsbandverlaufs einer zweiten Ausführungsform eines erfindungsgemäß ausgebildeten Quantenkaskadenlasers): Diese Ausführungsform unterscheidet sich durch die in Fig. 1 dargestellte Ausführungsform durch eine andere Wahl der Topf- und Barrierendicken. Die Berechnungen erfolgen mit den gleichen Materialkompositionen wie in Fig. 1 verwendet, also auf InP gitterangepasstes InGaAs als Topfmaterial und AlAsSb als Barrierenmaterial. Die damit erzielte Übergangswellenlänge beträgt 1.75 µm. Die genaue Schichtfolge der Struktur ist in folgender Tabelle angegeben. Die unterstrichenen Werte geben einen möglichen Bereich der Übergangsschicht an, der n-Typ dotiert ist.

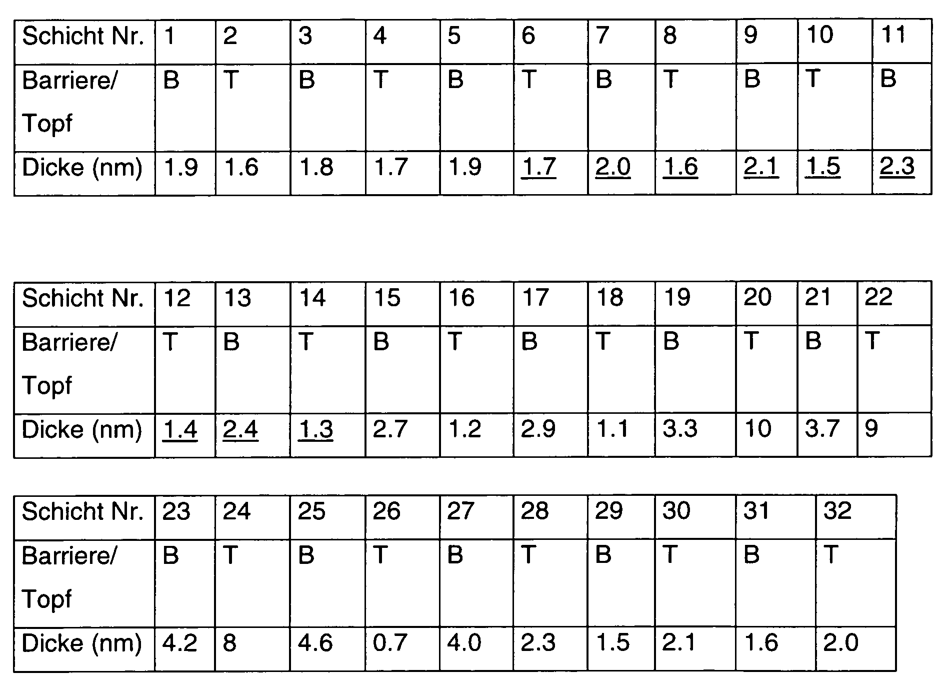

Fig. 1 und Fig. 2 zeigen zwei mögliche Ausführungsformen der hier vorteilhaft beschriebenen Erfindung. Aus diesen können Variation der Komposition und Schichtdicken abgeleitet werden, um Quantenkaskadenlaser im Wellenlängenbereich zwischen 3,4 µm und 1,5 µm zu realisieren.

### Quantenkaskadenlaser

### Bezugszeichenliste

- 1: Optisch aktiver Bereich
- 2: Übergangsbereich
- 3: Halbleiter-Vielschichtstruktur
- 4: oberes Energieniveau im optisch aktiven Bereich
- 5: unteres Laserniveau im optisch aktiven Bereich
- 6: tiefstes Energieniveau im optisch aktiven Bereich

## Patentansprüche

1. Quantenkaskadenlaser, der eine periodische Abfolge einer Vielzahl aufeinander aufgewachsener Halbleiter-Vielschichtstrukturen aufweist, welche aus einer Mehrzahl von epitaktisch aufeinander gewachsenen Barrierenschichten und Topfschichten bestehen, und in dem durch Anbringen zweier elektrischer Kontakte an diese Vielfach-Vielschichtstruktur und Anlegen eines elektrischen Feldes die elektronische Potentialstruktur der Vielfachschichtstruktur in der Art modifiziert wird, dass durch dieselbe ein elektrischer Strom bestehend aus Elektronen fließt, und die Vielschichtstruktur wenigstens einen optisch aktiven Bereich (1) enthält, der wenigstens einen Quantentopf aufweist, der wenigstens ein oberes (4) und wenigstens ein unteres Energieniveau (5) für Elektronen aufweist, und in besagtem optisch aktivem Bereich die Elektronen Übergänge zwischen dem oberen (4) und dem unteren Energieniveau (5) unter Abgabe von Photonen der Energie der Energiedifferenz des unteren und oberen Energieniveaus vollziehen, und im Quantenkaskadenlaser die Vielfachschichtstruktur einen Übergangsbereich (2) bestehend auf Halbleiter-Vielfachschichten ausweist, durch den Elektronen vom untersten Energieniveau (6) des optisch aktiven Bereichs in das obere Energieniveau (4) des nächsten in Flußrichtung der Elektronen liegenden optisch aktiven Bereichs (1) transportiert werden, **dadurch gekennzeichnet, dass** die Halbleiter-Vielschichtstruktur aus InGaAs als Material der Topfschicht und AlAsSb als Material der Barrierenschicht besteht.

2. Quantenkaskadenlaser nach Anspruch 1, **dadurch gekennzeichnet, dass** die Dicke mindestens einer Topfschicht im optisch aktiven Bereich zwischen 1 und 4 nm beträgt.

3. Quantenkaskadenlaser nach Anspruch 1 und 2, **dadurch gekennzeichnet, dass** die Dicke der Topfschicht im aktiven Bereich eine Energiedifferenz zwischen dem oberen Energieniveau des optisch aktiven Bereichs und dem unteren Energieniveau des optische aktiven Bereichs bewirkt, die einer Wellenlänge kürzer als 3,4 µm und größer als 1,5 µm entspricht.

4. Quantenkaskadenlaser nach Anspruch 1, **dadurch gekennzeichnet, dass** die Halbleiter-Vielfachschichtstruktur aus In_{0,53}Ga_{0,47}As als Topfmaterial und AlAs_{0,56}Sb_{0,44} als Barrierenmaterial besteht, die gitterangepasst zu einem InP-Substrat sind.

5. Quantenkaskadenlaser nach Anspruch 1 und 2, **dadurch gekennzeichnet, dass** die Halbleiter-Vielfachschichtstruktur aus In_{0,53±0,05}Ga_{0,47±0,05}As in der Topfschicht und AlAs_{0,56±0,05}Sb_{0,44±0,05} in der Barrierenschicht mit Abweichungen der Stöchiometrie von der zu einem auf InP-Substrat gitterangepassten Stöchiometrie sind, wobei die Anteile des In und Ga in den Topfschichten und des As und Sb in den Barrierenschichten in ihrer Summe 1,0 ergeben, so dass die Gesamtstruktur spannungskompensiert zu einem InP-Substrat ist.
